**Europäisches Patentamt**

**European Patent Office**

**Office européen des brevets**

(19)

(11) Veröffentlichungsnummer : **0 109 569**
**B1**

(12)
# EUROPÄISCHE PATENTSCHRIFT

(45) Veröffentlichungstag der Patentschrift :
09.09.87

(51) Int. Cl.⁴ : **H 05 K 5/00**

(21) Anmeldenummer : 83110507.7

(22) Anmeldetag : 21.10.83

(54) **Einschub für einen elektrischen Anlagenschrank.**

(30) Priorität : 22.11.82 DE 3243130

(43) Veröffentlichungstag der Anmeldung :
30.05.84 Patentblatt 84/22

(45) Bekanntmachung des Hinweises auf die Patenterteilung : 09.09.87 Patentblatt 87/37

(84) Benannte Vertragsstaaten :
**AT BE CH DE GB LI NL SE**

(56) Entgegenhaltungen :
CH-A- 526 899
DE-A- 2 515 163
DE-A- 2 946 114
FR-A- 2 491 284

(73) Patentinhaber : **BBC Aktiengesellschaft Brown,
Boveri & Cie.
Haselstrasse
CH-5401 Baden (CH)**

(72) Erfinder : **Grass, Hermann
Grenzhofer Strasse 76
D-6803 Edingen (DE)**
Erfinder : **Hammermüller, Otto
Rembrandtstrasse 7
D-6805 Heddesheim (DE)**
Erfinder : **Beckenbach, Gerhard
Schubertstrasse 2
D-6945 Hirschberg (DE)**
Erfinder : **Florig, Hans-Friedrich
Am Binsenberg 6
D-6943 Birkenau (DE)**

(74) Vertreter : **Kempe, Wolfgang, Dr. et al
c/o BROWN, BOVERI & CIE AG ZPT Postfach 351
D-6800 Mannheim 31 (DE)**

## Beschreibung

Die Erfindung bezieht sich auf einen in einen elektrischen Anlagenschrank einfügbaren Einschub, dessen Aufbau sich im wesentlichen aus einem Bodenteil mit seitlich daran angrenzenden Abdeckungen sowie aus einer Frontwandung und einer Rückwandung zusammensetzt.

Seit vielen Jahren findet im elektrischen Anlagenbau mit gutem Erfolg die sogenannte Einschubtechnik Anwendung. Dieses ist insbesondere der Fall bei elektrischen Anlagen zur Steuerung, Regelung und Überwachung von Großanlagen wie beispielsweise Kraftwerken, Netzverteilerstationen und Fabrikationsbetrieben, ebenso aber auch bei Sendeanstalten, Verkehrsleitsystemen und schließlich auch in der Computertechnik. Hierbei werden in entsprechend ausgestattete Anlagenschränke oder auch Gerüste Einschübe eingefügt, welche nicht nur zu Wartungszwecken und auch zur Überprüfung herausnehmbar sind, sondern darüberhinaus auch problemlos und schnell gegen andere Ersatzeinschübe auswechselbar sind. Auf diese Weise sind evtl. auftretende Störungen oder Betriebsunterbrechungen infolge defekter Funktionselemente innerhalb kürzester Zeit zu beheben.

Der Aufbau dieser Einschübe kann auf die unterschiedlichste Weise erfolgen, nämlich beispielsweise als Rahmengestell, an welchem nun die entsprechenden Wandungen und auch Chassis befestigt werden können. Es findet aber auch eine regelrechte Kastenbauweise Anwendung, wobei entsprechend gekantete und in ihren Eckbereichen miteinander verbundene Bleche Verwendung finden.

Eine noch andere Art des Aufbaues eines Einschubes für die genannten Zwecke besteht darin, die frontseitige Wandung und eine Rückwandung mittels versteifter seitlicher Schienen fest miteinander zu verbinden, wodurch ein steifer Rahmen gebildet wird, an welchem nun die zu befestigende Teile des Einschubes selbst und — gegebenenfalls über weitere Verbindungsschienen — die im Einschub aufzunehmenden elektrischen Funktionsteile befestigt werden können. Zur Vermeidung einer größeren Anzahl von zusammenzufügenden Schienen und anzugliedernden Befestigungselementen für die im Einschub aufzunehmende elektrischen Funktionsteile ist eine Profilschiene entwickelt und bekanntgeworden, welche einem Einschub nicht nur als Seitenwandung dienen, sondern darüberhinaus auch zur rastenden Aufnahme von elektrischen Funktionsgliedern Verwendung finden kann (DE-AS-25 15 163). Hierbei werden zwei gleiche und auch gleich lange Profilschienen je Einschub benötigt, ansonsten erweist sich der Zusammenbau des Einschubes jedoch verblüffend einfach. Geeignet sind derartige Profilschienen für Einschübe mit einer gewissen Mindestbreite, damit die auf den einander spiegelbildlich gegenüberstehenden Profilschienen aufschnappbaren elektrischen Funktionselemente nicht miteinander kollidieren.

Mit zunehmender Verfeinerung der Modultechnik und auch Verkleinerung der in den einzelnen Modulen — also z. B. in den Einschüben — aufzunehmenden Funktionselemente erhöht sich nun aber der Bedarf an — verglichen mit den früher üblichen Einschüben — kleinen Einschubeinheiten, wofür sich die bisher üblichen Bauweisen für Einschübe nicht sonderlich eignen oder aber zu aufwendig sind, und zwar sowohl bezüglich der benötigten Anzahl von Teilen als auch hinsichtlich des Montageaufwandes.

Aufgabe der vorliegenden Erfindung ist es, einen Einschub für die geschilderten Bedarfsfälle zu schaffen, welcher einfach im Aufbau, preisgünstig in der Herstellung und Montage, zudem platzsparend und dennoch hinreichend stabil und verwindungssteif ist.

Erfindungsgemäß wird dieses Ziel mit einem Einschub erreicht, dessen Bodenteil als tragendes Bauteil in Form wenigstens eines abgelängten Strangpreßprofiles ausgebildet ist, wobei die nach außen gerichtete Bodenfläche des Strangpreßprofiles eine etwa C-förmige Einformung zur Aufnahme einer im Anlagenschrank befindlichen Tragschiene aufweist, wobei weiterhin die seitlichen Randungen des Strangpreßprofiles von seitlich nach außen hin offenen, ebenfalls C-förmigen Anformungen zur Aufnahme von seitlichen Abdeckungen begrenzt sind und wobei im übrigen die Profilierung des Strangpreßprofiles wenigstens zwei von der Bodenfläche und den seitlichen Randungen in deutlichem Abstand befindliche Kanäle mit etwa kreisförmigen, in einem kleinen Umfangsbereich aufgetrennten Öffnungen aufweist, welch letztere der Aufnahme von Schrauben zur Befestigung der Frontwandung und der Rückwandung dienen. Im Gegensatz zu den vorher beschriebenen bekannten Einschüben dient bei dem erfindungsgemäß Einschub also das Bodenteil als wesentliches Tragteil und es wird nunmehr auch nur noch ein abgelängtes Strangpreßprofilteil benötigt, im Gegensatz zu beiderseits seitlich angeordneten Profilen, wie dieses vorher erwähnt wurde. Der erfindungsgemäße Einschub ist auch mit ganz wenigen Schrauben zusammenfügbar und insgesamt gesehen nicht nur platzsparend, sondern darüberhinaus auch kostengünstig herzustellen.

Eine vorteilhafte Weiterbildung des Erfindungsgedankens sieht vor, die der Bodenfläche entfernten freien Profilschenkel der seitlichen C-förmigen Anformungen des Bodenteiles gegenüber den ihnen entgegengerichteten bodennahen freien Profilschenkeln um das der Dicke der seitlichen Abdeckungen entsprechende Maß zurückspringen zu lassen. Auf diese Weise ist es möglich, insbesondere dann, wenn die seitlichen Abdeckungen — entsprechend einem weiteren Ausgestaltungsvorschlag — an ihren unteren, in die seitlichen C-förmigen Anformungen des Strangpreßprofiles eingreifenden Randungsbereiche mit Abkröpfungen versehen sind, eine stufenlose, ebene seitliche Wandungsfläche zu erhalten, was bei Einschüben der genannten Art stets als vorteilhaft empfunden wird.

Vorteilhaft kann es auch sein, im Mittelschenkel der C-förmigen bodenseitigen Einformung am Strangpreßprofil eine Führungsnut auszubilden. Eine derartige Führungsnut erweitert die Möglichkeiten für die Ausbildung von Führungsschienen im Anlagenschrank.

Ein anderer vorteilhafter Ausgestaltungsvorschlag befaßt sich mit der Bildung der die Befestigungsschrauben aufnehmenden Kanäle am Strangpreßprofil, und zwar wird vorgeschlagen, vom Mittelschenkel der C-förmigen bodenseitigen Einformung am Strangpreßprofil zwei etwa senkrecht zur Bodenfläche stehende, ins Einschubinnere gerichtete Profilstege ausgehen zu lassen, welche in ihrem Verlauf eine Profilnut sowie je einen sich etwa parallel zur Bodenfläche erstreckenden weiteren Steg aufweisen, an dessen Ende nun einer der besagten Kanäle angeformt ist. Auf diese Weise wird eine gute stirnseitige Anlagefläche sowohl für die Frontwandung als auch für die Rückwandung erzielt und es wird vermieden, daß die Befestigungsstellen der genannten Teile zu nahe am Einschubboden liegen. Dieses ist nicht nur optisch günstiger, sondern außerdem kann auf diese Weise eine weitere vorteilhafte Ausgestaltung Platz greifen, nämlich die frontseitigen Schrauben können gleichzeitig zur Befestigung eines Einschubgriffes an der Frontwandung dienen.

Als vorteilhaft erweist sich auch ein Vorschlag, demzufolge die freien Enden der beiden ins Einschubinnere gerichteten Profilstege in voneinander weisenden Abwinkelungen münden, welche zusammen ein Aufschnappsystem nach Art einer genormten Hutprofilschiene bilden. Dieser Vorschlag ähnelt einer Ausgestaltung der eingangs bereits genannten Profilschiene (gamäß DE-AS-25 15 163) für seitliche Einschubwandungen, mit dem Unterschied, daß die in diesem Einschub aufschnappbaren elektrischen Funktionselemente nun aufrecht stehen und nicht an Seitenwandungen « hängen » ; diese stehende Bauweise für die aufzuschnappenden Funktionselemente setzt sie weniger der Gefahr einer unerwünschten Belastung beispielsweise bei einem harten Aufsetzen eines herausgezogenen Einschubes aus. Außerdem ist, je nach Gestaltung der einzelnen Funktionselemente, die Zugänglichkeit zu ihren Anschlußklemmen oder Bedienungsteilen häufig vorteilhafter.

Bei geschickter Bemessung und Anordnung der bereits erläuterten Profilierung des Strangprofiles ist es möglich, die sich oberhalb der Bodenfläche des Strangpreßprofiles zwischen den ins Einschubinnere gerichteten Profilstegen sowie zwischen diesen und den C-förmigen Anformungen an den seitlichen Randungen des Strangpreßprofiles bildenden Räume als Kabelaufnahmeräume auszubilden und als solche zu nutzen. Hierbei ergibt sich der Vorteil, daß die in diesen Räumen angeordneten Kabel und Steuerleitungen weitgehend geschützt und sogar teilweise überdeckt sind.

Erwähnt wurden bereits die vorgeschlagenen Abkröpfungen an den seitlichen Abdeckungen, welche in die seitlichen C-förmigen Anformungen am Strangpreßprofil eingreifen. Zusätzlich wird der vorteilhafte Vorschlag gemacht, die seitlichen Abdeckungen an ihren den Abkröpfungen entgegengerichteten Randungen mit zueinanderweisenden, der Versteifung dienenden Abwinkelungen zu versehen, sowie sie mit an den Endbereichen dieser Abwinkelungen angeordneten bzw. angeformten federnden Rasthaken auszustatten, welche ihrerseits in korrespondierenden Ausnehmungen an Randungen der Frontwandung und der Rückwandung einrastbar sind. Auf diese Weise ergibt sich eine sehr einfache und werkzeuglose Montagemöglichkeit für die besagten seitliche Abdeckungen und auch eine einfache Demontage dieser Abdeckungen für Wartungsarbeiten und dergleichen. Außerdem vermögen derartige Abdeckungen nicht nur die Gesamtstabilität des Einschubes wesentlich zu verbessern, sondern darüberhinaus können sie auch dazu beitragen, Zug- und Schubkräfte beim Ein- und Ausfahren des Einschubes zu übertragen. Diese Funktion der Kräfteübertragung ist noch verbesserbar durch Ausbrüche in den Randbereichen der Längsenden der seitlichen Abdeckungen, wobei von der Frontwandung und der Rückwandung ausgehende zapfenartige Vorsprünge in diese Ausbrüche hineinragen. Im übrigen ist es vorteilhaft, die seitlichen Abdeckungen zum Zwecke der Wärmeabfuhr mit großen perforierten Flächenbereichen auszustatten, womit ein stets unerwünschter Wärmestau innerhalb des einzelenen Einschubes vermieden wird und gleichzeitig eine Luftzirkulation innerhalb des ganzen Anlagenschrankes begünstigt ist.

Eine vorteilhafte Ausbildung des erfindungsgemäßen Einschubes ist weiterhin in dem Vorschlag zu sehen, sowohl die Frontwandung als auch die Rückwandung als (metallische) Spritzgußformteile oder stattdessen als Kunststofformteile auszubilden. Derartige Formteile bieten den Vorteil, bereits alle erforderlichen Ausnehmungen, Versteifungsrippen und sonstigen Anformungen aufzuweisen, ohne daß es hierfür besonderer Teile oder Arbeitsgänge bedürfte. Es ist sehr wohl auch möglich, wahlweise metallische oder aus Isolierstoff bestehende Formteile zu verwenden, womit der Anwendungsbereich des neuen Einschubes durchaus erweitert und auch seine Preisgestaltung variabler gestaltet werden kann.

Wie bereits im Zusammenhang mit der vorgeschlagenen Führungsnut im Mittelschenkel der C-förmigen bodenseitigen Einformung ausgeführt worden ist, ergeben sich mehrere Möglichkeiten der Gestaltung einer Tragschiene bzw. einer Tragvorrichtung für den Einschub. Vorgeschlagen hierfür wird eine Tragschiene mit T-förmiger Profilierung oder mit einer entsprechend bemessenen hutförmigen Profilierung. Dabei kann der U-förmige Bereich solch einer Hutprofilschiene entweder nach unten, also abgekehrt von der besagten Führungsnut angeordnet werden oder auch in diese Führungsnut zur zusätzlichen Führung und Stabilisierung des Einschubes eingreifen.

Nicht unerwähnt schließlich bleibe, daß es durchaus möglich ist und zudem sehr vorteilhaft sein kann, durch Nebeneinanderfügung zweier erfindungsgemäßer Strangpreßprofile und deren Verbindung mit Doppelfrontplatten und mit doppelt so breiten Rückwandungen einen praktisch doppelt so breiten Einschub zu schaffen gegenüber einem solchen mit nur einem bodenseitigen Strangpreßprofil. Durch Belassung einer breiteren Lücke zwischen zwei nebeneinander angeordneten Strangpreßprofilen ist die Breite eines Einschubes durchaus noch weiter vergrößerbar oder auch stattdessen durch Aneinanderfügung von mehr als zwei Strangpreßprofilen.

Anhand figürlicher Darstellungen von Ausführungsbeispielen des Erfindungsgegenstandes und der nachfolgenden Beschreibung hierzu sollen der Erfindungsgedanke und seine Ausbildungsmöglichkeiten noch einmal erläutert werden.

Es zeigt :

Figur 1 in einer perspektivischen Explosionsdarstellung alle wesentliche Teile eines Einschubes,

Figur 2 die Stirnansicht eines als Strangpreßprofil ausgebildeten Bodenteiles eines Einschubes mit einem der anzufügenden seitlichen Abdeckungen,

Figuren 3-6 unterschiedliche Ausführungsmöglichkeiten für den Einschub in einem Anlagenschrank aufnehmende Tragschienen und

Figur 7 in perspektiver Explosionsdarstellung einen verbreiterten Einschub mit einem aus zwei Strangpreßprofilen zusammengesetzten Bodenteil.

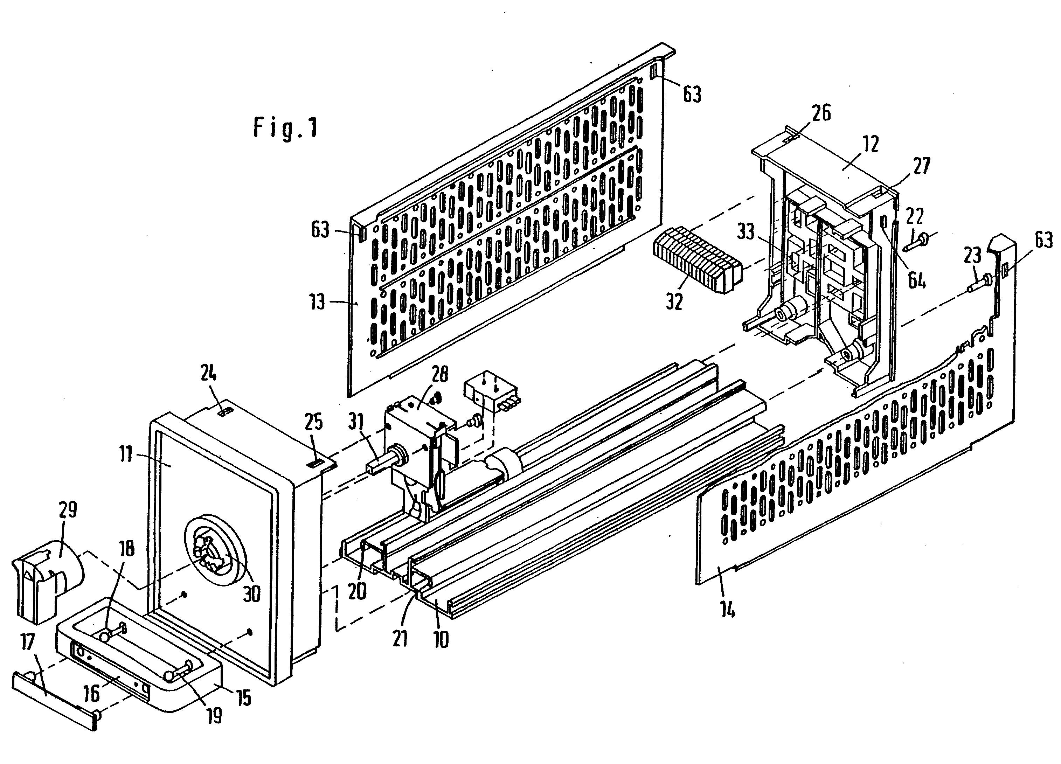

Der in Figur 1 veranschaulichte erfindungsgemäße Einschub für einen Anlagenschrank setzt sich im wesentlichen zusammen aus einem als Strangpreßprofil ausgebildeten Bodenteil 10, aus einer Frontwandung 11, einer Rückwandung 12 und schließlich aus seitlichen Abdeckungen 13 und 14. Sowohl die Frontwandung 11 als auch die Rückwandung 12 stellen Kunststofformteile dar, sie können aber auch ebensogut, insbesondere was die Frontwandung betrifft, als metallische Spritzgußformteile ausgebildet sein. Der Frontwandung 11 ist ein Einschubgriff 15 mit einer darin in einer Versenkung 16 einrastbaren Platte 17 zugeordnet. Mittels Befestigungsschrauben 18 und 19 werden sowohl der Einschubgriff 15 als auch die Frontwandung 11 am Bodenteil 10 befestigt, und zwar durch Einschrauben dieser Befestigungsschrauben 18 und 19 in entsprechend ausgeformte Kanäle 20 und 21 am als Strangpreßprofil ausgebildeten Bodenteil 10. In eben diese Kanäle 20 und 21, jedoch von der entgegengerichteten Seite des Bodenteils 10 her, werden rückseitige Befestigungsschrauben 22 und 23 zur Befestigung der Rückwandung 12 eingeführt. Die seitlichen Abdeckungen 13 und 14 bedürfen keiner besonderen Befestigungsteile, da sie an den seitlichen Randungsbereichen des Bodenteiles 10 in entsprechende Ausformungen eingelegt und anschließend mit in dieser Darstellung nicht unmittelbare erkennbaren Rastnasen in Ausnehmungen 24, 25, 26 und 27 an der Frontwandung 11 bzw. Rückwandung 12 eingerastet werden. Außerdem weisen sie Ausbrüche 63 auf, in welche zapfenartige Vorsprünge 64 (erkennbar ist lediglich ein solcher an der Rückwandung 12) eingreifen, die von der Frontwandung 11 und der Rückwandung 12 seitlich ausgehen.

Zur Andeutung der Bestückungsmöglichkeiten des dargestellten Einschubes ist ein von vorne in das Bodenteil 10 einschiebbarer Verriegelungsmechanismus 28 für einen Leistungs- bzw. Lastschalter mit einem zugeordneten Betätigungsknebel 29 veranschaulicht. Es ist erkennbar, daß die Frontwandung 11 zur Aufnahme des Verriegelungsmechanismus 28 mit einer speziellen Öffnung 30 ausgestattet ist, durch welche eine Betätigungsachse 31 des Verriegelungsmechanismus 28 ragen kann. Weitere Einzelheiten hierzu sind hier nicht von Interesse, es sei lediglich erwähnt, daß für die Aufnahme anderer elektrischer Funktionselemente oder anders gearteter Schalter bzw. Verriegelungsmechanismen Frontwandungen 11 mit anderer Ausbildung von Aufnahmeelementen für elektrische Funktionselemente Verwendung finden können.

Auch die Rückwandung 12 kann der Aufnahme von elektrischen Funktionselementen oder Anschlußklemmen und dergleichen dienen, beispielsweise einem vielpoligen Steckerelement 32 bzw. einem Paket von mehreren einpoligen Steckerelementen. Außerdem ist die Rückwandung 12 mit einer Anzahl von Durchtrittsöffnungen versehen, die dem Durchtritt von Leistungszugängen und Leistungsabgängen — vorzugsweise ebenfalls als steckbare Glieder ausgebildet — dienen ; eine dieser Durchtrittsöffnungen ist, stellvertretend für alle übrigen erkennbaren Durchtrittsöffnungen, mit der Ziffer 33 versehen worden.

Wie aus der Darstellung und den vorstehenden Erläuterungen zu entnehmen, ist der Zusammenbau dieses erfindungsgemäßen Einschubes sehr einfach und schnell zu bewerkstelligen, denn es bedarf lediglich des Einschraubens der vier genannten Befestigungsschrauben 18, 19, 22 und 23 und des anschließenden Einlegens und Einrastens der seitlichen Abdeckungen 13 und 14. Dementsprechend einfach ist auch ein unter Umständen zur einfacheren Bestückung bzw. Verdrahtung des Inneren des Einschubes erforderliches Lösen eines der Wandungsteile zu vollziehen.

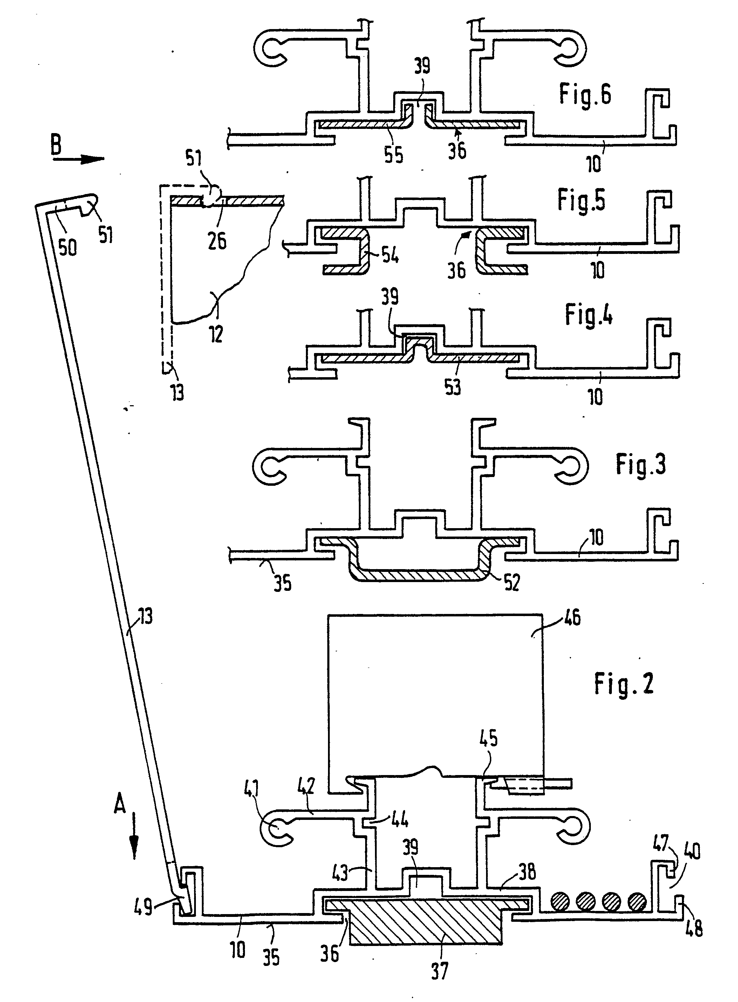

Die Figur 2 veranschaulicht eine stirnseitige Sicht auf das als Strangpreßprofil ausgebildete Bodenteil 10 und die seitliche Abdeckung 13 in ihrer zwar in das Bodenteil 10 bereits eingelegten, jedoch noch nicht eingerasteten Lage. Es ist erkennbar, daß die nach außen gerichtete Bodenfläche 35 eine etwa C-förmige Einformung 36 zur Aufnahme einer im Anlagenschrank befindlichen Tragschiene 37 aufweist. Innerhalb dieser C-förmigen Einformung 36 ist — in deren Mittelschenkel 38 — eine zusätzliche Führungsnut 39 eingeformt, deren Aufgabe nachfolgend noch erläutert werden soll. An beiden seitlichen Randungen des Bodenteiles 10 sind außerdem seitlich nach außen hin offene, ebenfalls etwa C-förmige Anformungen 40 angeordnet, welche, wie in der Darstellung links ersichtlich, zur Aufnahme der seitlichen Abdeckungen 13 und 14 (siehe auch Figur 1) dienen. Sowohl von der Bodenfläche 35 als auch von den seitlichen C-förmigen Anformungen 40 deutlich beabstandet befinden sich Kanäle 41 mit etwa kreisförmigen, in einem kleinen Umfangsbereich aufgetrennten Kanalöffnungen, die der Aufnahme von Schrauben zur Befestigung sowohl der Frontwandung als auch — am entgegengesetzten, nicht sichtbaren Ende des Bodenteiles 10 — der Rückwandung dienen. Diese Kanäle 41 befinden sich am Ende von etwa parallel zur Bodenfläche 35 sich erstreckenden Stegen 42, welche ihrerseits von Profilstegen 43 ausgehen, welche oberhalb des Mittelschenkels 38 der C-förmigen bodenseitigen Einformung 36 gelegen sind. Die Profilstege 43 weisen außerdem Profilnuten 44 auf, welche der Aufnahme von (nicht angedeuteten) elektrischen Funktionselementen oder einer einzufügenden Zwischenwand (eine solche ist ebenfalls nicht gezeigt) dienen können. Nicht unerwähnt bleibe, daß die Profilstäbe 43 an ihren freien, ins Einschubinnere gerichteten Enden voneinanderweisende Abwinkelungen 45 aufweisen, welche zusammen ein Aufschnappsystem nach Art einer genormten Hutprofilschiene bilden und elektrische Funktionselemente (ein solches ist mit seinen Umrissen angedeutet und mit der Ziffer 46 gekennzeichnet worden), aufzunehmen vermögen. Voraussetzung ist natürlich, daß die elektrischen Funktionselemente für eine entsprechend Schnappbefestigung auf Hutprofilschienen eingerichtet sind.

Wie bereits ausgeführt, dienen die seitlichen C-förmigen Anformungen 40 der Aufnahme der seitlichen Abdeckungen, von denen die (in der Darstellung) linksseitige auch dargestellt ist. Hingewiesen darf darauf werden, daß die der Bodenfläche 35 entfernteren Profilwinkel 47 der seitlichen C-förmigen Anformungen 40 des Bodenteiles 10 gegenüber den ihnen entgegengerichteten bodennahen freien Profilschenkeln 48 um ein etwa der Dicke der seitlichen Abdeckungen 13 entsprechendes Maß zurückspringen.

Hierdurch ist erreichbar, daß die seitlichen Abdeckungen 13 in ihrer eingelegten Lage nicht über der äußeren Begrenzung des Bodenteiles 10 vorstehen, jedenfalls dann nicht, wenn sie mit einer Abkröpfung 49 an ihrem (in der Darstellung) unteren Wandbereich versehen sind. Wie erkennbar, ist diese Abkröpfung so ausgeführt, daß sich hier eine senkrecht zur Erstreckungsebene der Abdeckung 13 verlaufende schmale Fläche bildet, welche sich in montierter Lage der seitlichen Abdeckung 13 satt an die Stirnseite des angrenzenden Profilschenkels 47 anlegt, so daß die Abdeckung 13 nicht in vertikaler Richtung hochgleiten kann. Am entgegengesetzten Randbereich der Abdeckungen 13 und 14 (siehe Figur 1) sind der Versteifung dienende Abwinkelungen 50 erkennbar und an deren Längsenden zusätzlich noch federnd nachgiebige Rasthaken 51 vorgesehen. Diese Rasthaken 51 wirken mit den in Figur 1 bereits gezeigten Ausnehmungen 24 bis 27 in der Frontwandung 11 beziehungsweise in der Rückwandung 12 zusammen, was auch in der Darstellung in Figur 2 rechts vom gezeigten Rasthaken 51 gezeigt ist. Hier ist — schematisiert — die Rückwandung 12 mit der Öffnung 26 angedeutet und, mit unterbrochener Linienführung, auch die Abdeckung 13 samt ihrem Rasthaken 51 in ihrer montierten Lage.

Es ist bereits erläutert worden, daß zur Halterung und zur Führung eines Einschubes, wie er beschrieben worden ist, im Schaltschrank angeordnete Tragschienen dienen, und eine solche mit etwa T-förmiger Profilierung ist in der Figur 2 auch gezeigt und mit der Ziffer 37 versehen worden. Andere vorteilhafte Ausbildungsmöglichkeiten solcher Trag- und Führungsschienen veranschaulichen die Figuren 3 bis 6, in welchen das bereits eingehend erläuterte Bodenteil 10 auf unterschiedliche Tragschienen aufgebracht worden ist. In der Figur 3 handelt es sich um eine Hutprofilschiene 52, deren U-förmiger Bereich von der Bodenfläche 35 des Bodenteiles 10 abgewandt ist. Auch die Figur 4 veranschaulicht eine hutprofilförmige Tragschiene 53, deren U-förmiger Bereich jedoch entgegengesetzt der vorher genannten Tragschiene 52 gelegen ist, und zwar ragt der U-förmige Bereich dieser Tragschiene 53 in die bereits weiter oben erwähnte Führungsnut 39 hinein. Bei der Anordnung gemäß Figur 5 findet nun ein Tragschienenpaar 54 mit U-förmiger Profilgebung Verwendung, wobei die freien Schenkel dieser Tragschienen 54 voneinander gerichtet sind und jeweils einer ihrer Schenkel ragt in die umschlossenen Bereiche der C-förmigen Einformung 36 hinein. In Figur 6 schließlich findet ebenfalls ein Tragschienenpaar 55 Verwendung, hier aber in Form von ungleichschenkeligen Winkelschienen. Die kurzen Schenkel ragen hierbei in die bereits genannte Führungsnut 39 hinein, die langen Schenkel hingegen füllen die C-förmige Einformung 36 im wesentlichen aus.

Alle dargestellten Tragschienen bzw. Tragschienenpaare erfüllen im gleichen Maße ihren Zweck, so daß bei der Auswahl des jeweils bevorzugten Systems Fragen der Befestigung dieser Tragschienen im Anlagenschrank oder andere Gesichtspunkte entscheidend sein können.

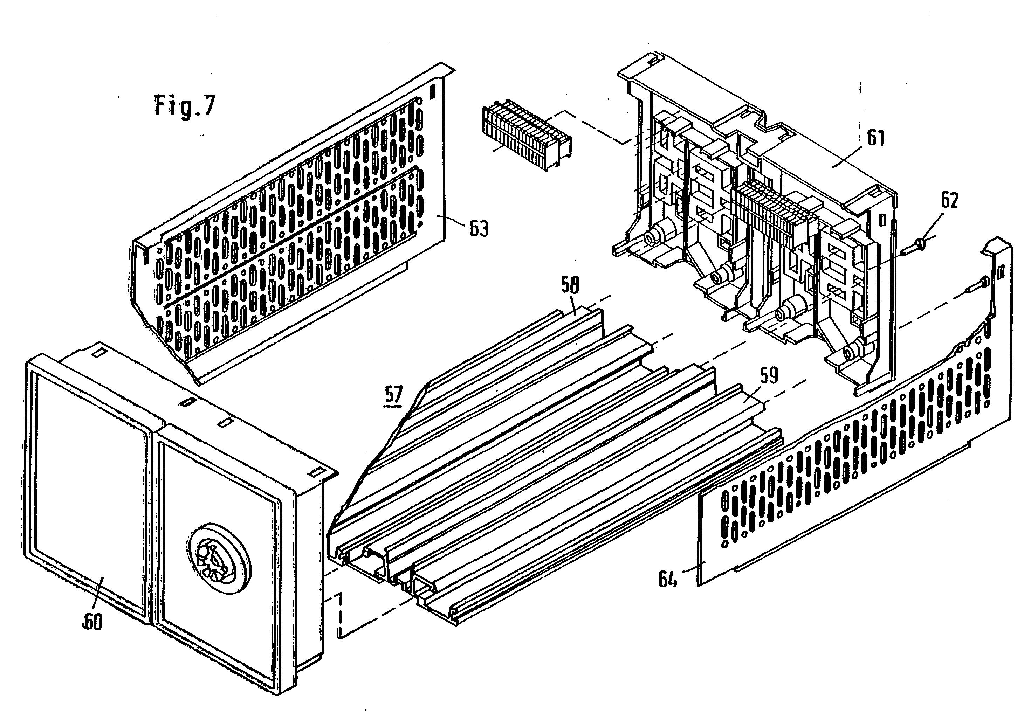

Schließlich zur Figur 7. Hierin ist ein gegenüber dem in Figur 1 gezeigten Einschub in seiner Breite verdoppelter Einschub gezeigt, bei welchem das Bodenteil 57 aus zwei gleichlangen Strangpreßprofilteilen 58 und 59 gleicher Ausbildung, wie dieses in den Figuren 1 und 2 gezeigt worden ist, zusammengesetzt ist. Diese Strangpreßprofile 58 und 59, die übrigens miteinander verbunden sein können aber nicht sein müssen, sind nun mit je einer entsprechend breiten Frontwandung 60 und einer Rückwandung 61 verbindbar, und zwar in gleicher Weise (also mittels entsprechender Schrauben 62) wie dieses beim zuvor erläuterten schmalen Einschub der Fall ist. An einen so zusammengefügten Einschub können nun in ebenfalls bereits geschilderter Weise seitliche Abdeckungen 63 und 64 angefügt werden, welche denen für schmale Einschübe gemäß Figur 1 völlig gleichen können. Weitere Erläuterungen erübrigen sich zu dieser Darstellung.

Wie bereits eingangs der Figurenbeschreibung ausgeführt, zeigen die Darstellungen lediglich Ausführungsbeispiele für den Erfindungsgedanken. Mannigfache Abweichungen von den gezeigten Ausführungen sind durchaus denkbar. Beispielsweise ist es möglich, einen « breiten » Einschub, wie er in der Figur 7 veranschaulicht ist, noch weiter zu verbreitern, indem zwischen den Strangpreßprofilen 58 und 59 eine Lücke belassen wird, welche entweder offen bleiben kann oder auch mittels eines in die seitlichen C-förmigen Anformungen einfügbaren zusätzlichen Bodenteiles verschlossen werden kann.

### Patentansprüche

1. In einen elektrischen Anlagenschrank einfügbarer Einschub, dessen Aufbau sich im wesentlichen aus einem Bodenteil mit seitlich daran angrenzenden Abdeckungen sowie aus einer Frontwandung und einer Rückwandung zusammensetzt, dadurch gekennzeichnet, daß das Bodenteil (10, 57) als tragendes Bauteil in Form wenigstens eines abgelängten Strangpreßprofiles (10 ; 58, 59) ausgebildet ist, dessen nach außen gerichtete Bodenfläche (35) eine etwa C-förmige Einformung (36) zur Aufnahme einer im Anlagenschrank befindlichen Tragschiene (37 ; 52... 55) aufweist, dessen seitliche Randungen von seitlich nach außen hin offenen, ebenfalls C-förmigen Anformungen (40) zur Aufnahme der seitlichen Abdeckungen (13, 14 ; 63, 64) begrenzt sind und dessen Profilierung im übrigen wenigstens zwei von der Bodenfläche und den seitlichen Randungen in deutlichem Abstand befindliche Kanäle (41) mit etwa kreisförmigen, in einem kleinen Umfangsbereich aufgetrennten Kanalöffnungen aufweist, welche der Aufnahme von Schrauben (18, 19, 22, 23 ; 62) zur Befestigung der Frontwandung (11, 60) und der Rückwandung (12, 61) dienen.

2. Einschub nach Anspruch 1, dadurch gekennzeichnet, daß die der Bodenfläche (35) entfernteren freien Profilschenkel (47) der seitlichen C-förmigen Anformungen (40) des Bodenteiles (10) gegenüber den ihnen entgegengerichteten bodennahen freien Profilschenkeln (48) um das der Dicke der seitlichen Abdeckungen (13, 14 ; 63, 64) entsprechende Maß zurückspringen.

3. Einschub nach Anspruch 1 oder 2, dadurch gekennzeichnet, daß im Mittelschenkel (38) der C-förmigen bodenseitigen Einformungen (36) am Bodenteil (10) eine Führungsnut (39) ausgebildet ist.

4. Einschub nach wenigstens einem der Ansprüche 1 bis 3, dadurch gekennzeichnet, daß vom Mittelschenkel (38) der C-förmigen bodenseitigen Einformung (36) am Bodenteil (10 ; 57) zwei etwa senkrecht zur Bodenfläche (35) stehende, ins Einschubinnere gerichtete Profilstege (43) ausgehen, welche in ihrem Verlauf je eine Profilnut (44) sowie je einen sich etwa parallel zur Bodenfläche erstreckenden weiteren Steg (42) aufweisen, an dessen Ende einer der Kanäle (41) für die Schraubbefestigung von Frontwandung (11, 60) und Rückwandung (12, 61) angeformt ist.

5. Einschub nach Anspruch 4, dadurch gekennzeichnet, daß die Anformungen an den beiden ins Einschubinnere gerichtete Profilstegen (43) spiegelbildlich zueinander ausgerichtet sind, wobei die weiteren Stege (42) mit den Kanälen (41) an ihren Enden voneinanderweisen.

6. Einschub nach Anspruch 4 oder 5, dadurch gekennzeichnet, daß die freien Enden der beiden ins Einschubinnere gerichteten Profilstege (43) in voneinanderweisenden Abwinkelungen (45) münden, welche zusammen ein Aufschnappsystem nach Art einer genormten Hutprofilschiene bilden.

7. Einschub nach einem der Ansprüche 4 bis 6, dadurch gekennzeichnet, daß sich oberhalb der Bodenfläche (35) des Bodenteiles (10, 57) zwischen den ins Einschubinnere gerichteten Profilstegen (43) sowie zwischen diesen und den C-förmigen Anformungen (40) an den seitlichen Randungen des Bodenteiles als Kabelaufnahmeräume nutzbare Kabelkanäle bilden.

8. Einschub nach wenigstens einem der Ansprüche 1 bis 7, dadurch gekennzeichnet, daß die seitlichen Abdeckungen (13, 14 ; 63, 64) an ihren unteren, in die seitlichen C-förmigen Anformungen (40) des Bodenteiles (10, 57) eingreifenden Randungsbereichen Abkröpfungen (49) aufweisen, wodurch Anlagenflächen sowohl an die bodennahen freien Profilschenkel (48) der C-förmigen Anformungen als auch an die Endflächen der entgegengerichteten freien Profilschenkel (47) gebildet sind.

9. Einschub nach Anspruch 8, dadurch gekennzeichnet, daß die seitlichen Abdeckungen (13, 14 ; 63, 64) an ihren oberen, den Abkröpfungen (49) entgegengerichteten Randungen mit zueinanderweisenden versteifenden Abwinkelungen (50) sowie an den Endbereichen dieser Abwinkelungen mit federndem Rasthaken (51) versehen sind, welche in korrespondierenden Ausnehmungen (24...27) an Randungen der Frontwandung (11, 60) und der Rückwandung (12, 61) einrastbar sind.

10. Einschub nach Anspruch 8 oder 9, dadurch gekennzeichnet, daß die seitlichen Abdeckungen (13, 14 ; 63, 64) im Bereich zwischen den unteren Abkröpfungen (49) und den oberen Abwinkelungen (50) zum Zwecke der Wärmeabfuhr perforiert sind.

11. Einschub nach wenigstens einem der Ansprüche 1 bis 10, dadurch gekennzeichnet, daß die Frontwandung (11, 60) und die Rückwandung (12, 61) als (metallische) Spritzgußformteile oder als Kunststofformteile ausgebildet sind.

12. Einschub nach wenigstens einem der Ansprüche 1 bis 11, dadurch gekennzeichnet, daß die übrigen Einschubteile je nach vorgesehener Einschubbestückung mit Frontwandungen (11, 60) unterschiedlicher formmäßiger Ausbildung kombinierbar sind.

13. Einschub nach wenigstens einem der Anprüche 1 bis 12, dadurch gekennzeichnet, daß mittels der die Frontwandung (11, 60) mit dem Bodenteil (10, 57) an dessen kreisförmigen Kanälen (40) verbindenden Schrauben (18, 19) gleichzeitig ein Einschubgriff (15) an der Frontwandung befestigbar ist.

14. Einschub nach wenigstens einem der Ansprüche 1 bis 13, dadurch gekennzeichnet, daß als im Anlagenschrank befindliche und in die C-förmige Einformung (36) an der Bodenfläche (35) des Bodenteiles (10, 57) eingreifende Tragschiene, (37) für den Einschub eine solche mit T-förmiger Profilierung (37) oder eine Hutprofilschiene (52, 53) dient.

15. Einschub nach wenigstens einem der Ansprüche 1 bis 13, dadurch gekennzeichnet, daß als im Anlagenschrank befindliche und in die C-förmige Einformung (36) an der Bodenfläche (35) des Bodenteiles (10, 57) eingreifende Tragvorrichtung für den Einschub ein U-förmiges oder winkeliges Schienenpaar (54, 55) Verwendung findet.

16. Einschub nach wenigstens einem der Ansprüche 8 bis 10, dadurch gekennzeichnet, daß die seitlichen Abdeckungen (13, 14) in den Randbereichen ihrer Längsenden Ausbrüche zur Aufnahme von zapfenartigen Vorsprüngen aufweisen, welch letztere von der Frontwandung (11) und der Rückwandung (12) ausgehen.

**Claims**

1. Slide, which can be inserted in a cabinet for electrical systems and which is constructed essentially of a base part having cover plates laterally adjacent to it and of a front wall and a back wall, characterized in that the base part (10, 57) is designed as a supporting component in the form of at least one cross-cut extruded profile (10 ; 58, 59) whose outwardly directed base surface (35) has an approximately C-shaped recessed formation (36) for receiving a mounting rail (37 ; 52... 55) located in the system cabinet, the lateral edges of this base part being limited by laterally outwardly open integral formations (40) which are also C-shaped, for receiving the lateral cover plates (13, 14 ; 63, 64), and the profile of this base part also having at least two channels (41), located at a significant distance from the base surface and the lateral edges, with approximately circular channel openings which are opened up in a small area of the periphery and which serve to receive screws (18, 19, 22, 23 ; 62) for fastening the front wall (11, 60) and the back wall (12, 61).

2. Slide according to Claim 1, characterized in that the free sections (47) of the profile of the lateral C-shaped integral formations (40) of the base part (10) which are further away from the base surface (35) bend back towards the free sections (48) of the profile opposite which are closer to the base by an amount corresponding to the thickness of the lateral cover plates (13, 14 ; 63, 64).

3. Slide according to Claim 1 or 2, characterized in that a guiding groove (39) is formed on the base part (10) in the middle section (38) of the C-shaped recessed formations (36) on the base side.

4. Slide according to at least one of Claims 1 to 3, characterized in that on the base part (10 ; 57) two side webs (43) which are approximately at right angles to the base surface (35) and are directed towards the interior of the slide project from the middle section (38) of the C-shaped recessed formation (36) on the base side, these side webs (43) each having along their course a side groove (44) and each having a further web (42) extending approximately parallel to the base surface, one of the channels (41) for fastening the front wall (11, 60) and back wall (12, 61) with screws being formed on the end of this further web (42).

5. Slide according to Claim 4, characterized in that the integral mouldings on the two side webs (43) directed towards the interior of the slide are designed to be mirror images of one another, the further webs (42) with the channels (41) on their ends pointing away from one another.

6. Slide according to Claim 4 or 5, characterized in that the free ends of the two side webs (43) directed towards the interior of the slide open out into angledoff ends (45) pointing away from one another which together form a snap-on system of the type of a standardized hatsection rail.

7. Slide according to one of Claims 4 to 6, characterized in that cable channels usable as spaces for receiving cables are formed above the base surface (35) of the base part (10, 57) between the side webs (43) directed towards the interior of the slide and between these and the C-shaped integral mouldings (40) at the lateral edges of the base part.

8. Slide according to at least one of Claims 1 to 7, characterized in that the lateral cover plates (13, 14 ; 63, 64) have ends bent over (49) at their lower edge regions engaging in the lateral C-shaped integral formulations (40) of the base part (10, 57), by which means bearing surfaces are formed not only on the free profile sections (48), which are close to the base of the C-shaped integral formations but also on the end surfaces of the opposite free profile sections (47).

9. Slide according to Claim 8, characterized in that the lateral cover plates (13, 14 ; 63, 64) at their upper edges directed opposite the ends bent over (49), are provided with reinforcing bent-off ends (50) pointing towards one another and with resilient locking hooks (51) at the end regions of these bent-off ends, which locking hooks (51) can be locked into corresponding recesses (24-27) in edges of the front wall (11, 60) and the back wall (12, 61).

10. Slide according to Claim 8 or 9, characterized in that the lateral cover plates (13, 14 ; 63, 64) are perforated in the region between the lower ends bent over (49) and the upper bent-off ends (50) for the purpose of heat dissipation.

11. Slide according to at least one of Claims 1 to 10, characterized in that the front wall (11, 60) and the back wall (12, 61) are designed as (metal) injection mouldings or as plastic mouldings.

12. Slide according to at least one of Claims 1 to 11, characterized in that the other parts of the slide can be combined with front walls (11, 60) of variously shaped designs, depending on the components provided on the slide.

13. Slide according to at least one of Claims 1 to 12, characterized in that, by means of the screws (18, 19) connecting the front wall (11, 60) to the base part (10, 57) at the circular channels (40) of the latter, a slide handle (15) can be fastened to the front wall at the same time.

14. Slide according to at least one of Claims 1 to 13, characterized in that, as the mounting rail (37) for the slide, located in the system cabinet and engaging in the C-shaped recessed formation (36) on the base surface (35) of the base part (10, 57), there serves a mounting rail with a T-shaped profile (37) or a hat-section rail (52, 53).

15. Slide according to at least one of Claims 1 to 13, characterized in that, as the mounting device for the slide, located in the system cabinet and engaging in the C-shaped recessed formation (36) on the base surface (35) of the base part (10, 57), there is used a U-shaped or angled pair of rails (54, 55). ·

16. Slide according to at least one of Claims 8 to 10, characterized in that the lateral cover plates (13, 14) have holes in the edge regions of their longitudinal ends for receiving peg-shaped projections, the latter projecting from the front wall (11) and the back wall (12).

**Revendications**

1. Tiroir pouvant être inséré dans une armoire d'installation électrique, se composant essentiellement d'un élément de fond avec des panneaux latéraux adjacents ainsi que d'une paroi frontale et d'une paroi arrière, caractérisé en ce que l'élément de fond (10, 57) en tant qu'élément porteur est réalisé en forme au moins d'un profilé extrudé mis à longueur (10 ; 58, 59) dont la surface de fond (35) tournée vers l'extérieur présente une partie en creux (36) en forme de C pour la réception d'un rail de support (37 ; 52 ... 55) se trouvant dans l'armoire d'installation, dont les bords latéraux sont délimités par des parties saillantes (40) également en forme de C, ouvertes vers l'extérieur, destinées à la réception des panneaux latéraux (13, 14 ; 63, 64), et dont le profilage présente par ailleurs au moins deux canaux (41) se trouvant à une nette distance de la surface de fond et des panneaux latéraux et présentant des canaux de profil intérieur à peu près circulaire, ouverts sur une petite partie de la circonférence et servant à recevoir des vis (18, 19, 22, 23 ; 62) pour la fixation de la paroi frontale (11, 60) et de la paroi arrière (12, 61).

2. Tiroir selon la revendication 1, caractérisé en ce que les branches de profilé (47) libres, éloignées de la surface de fond (35), des parties saillantes (40) en C de l'élément de fond (10) sont en retrait par rapport aux branches de profilé (48) libres opposées, proches du fond, d'une distance correspondant à l'épaisseur des panneaux latéraux (13, 14 ; 63, 64).

3. Tiroir selon la revendication 1 ou 2, caractérisé en ce qu'une rainure de guidage (39) est réalisée sur l'élément de fond (10) dans la branche médiane (38) des parties en creux (36) en C côté fond.

4. Tiroir selon au moins l'une quelconque des revendications 1 à 3, caractérisé en ce que deux ailes de profilé (43) à peu près perpendiculaires à la surface de fond (35) et tournées vers l'intérieur du tiroir, partent de la branche médiane (38) de la partie en creux (36) en C côté fond de l'élément de fond (10 ; 57), ces ailes présentant dans leur tracé chacune une rainure de profilé (44) ainsi qu'une autre aile (42) s'étendant de façon à peu près parallèle par rapport à la surface de fond et présentant à son extrémité l'un des canaux (41) pour la fixation par vis de la paroi frontale (11, 60) et de la paroi arrière (12, 61).

5. Tiroir selon la revendication 4, caractérisé en ce que les parties saillantes sur les deux ailes de profilé (43) tournées vers l'intérieur du tiroir sont disposées de façon symétrique, et les autres ailes (42) avec les canaux (41) à leurs extrémités s'étendent en sens opposés.

6. Tiroir selon la revendication 4 ou 5, caractérisé en ce que les extrémités libres des deux ailes de profilé (43) tournées vers l'intérieur du tiroir se terminent par des rebords (45) orientés en sens opposés et formant ensemble un système d'encliquetage à la manière d'un profilé en chapeau normalisé.

7. Tiroir selon l'une quelconque des revendications 4 à 6, caractérisé en ce qu'au-dessus de la surface de fond (35) de l'élément de fond (10, 57) se forment entre les ailes de profilé (43) tournées vers l'intérieur du tiroir ainsi qu'entre ces ailes et les parties saillantes (40) en C sur les bords latéraux de l'élément de fond, des canaux pouvant être utilisés comme canaux récepteurs de câbles.

8. Tiroir selon au moins l'une quelconque des revendications 1 à 7, caractérisé en ce que les panneaux latéraux (13, 14 ; 63, 64) présentent dans leurs zones de bord inférieures, s'engageant dans les parties latérales saillantes (40) en C de l'élément de fond (10, 57), des contre-coudes (49), ce qui établit des surfaces d'appui aussi bien sur les branches libres (48), proches du fond, que sur les faces terminales des branches libres (47) opposées des parties saillantes (40) en C.

9. Tiroir selon la revendication 8, caractérisé en ce que les panneaux latéraux (13, 14 ; 63, 64) sont pourvus à leurs bords supérieurs opposés aux contre-coudes (49) de rebords (50) rigidifiants tournés l'un vers l'autre ainsi que, dans les zones terminales de ces rebords, de crochets élastiques (51) qui peuvent être encliquetés dans des creux correspondants (24 ... 27) sur des bords de la paroi frontale (11, 60) et de la paroi arrière (12, 61).

10. Tiroir selon la revendication 8 ou 9, caractérisé en ce que les panneaux latéraux (13, 14 ; 63, 64) sont perforés dans la zone entre les contre-coudes inférieurs (49) et les rebords supérieurs (50) en vue de la dissipation de la chaleur.

11. Tiroir selon au moins l'une quelconque des revendications 1 à 10, caractérisé en ce que la paroi frontale (11, 60) et la paroi arrière (12, 61) sont réalisées comme pièces (métalliques) moulées par injection ou comme pièces moulées en matière plastique.

12. Tiroir selon au moins l'une quelconque des revendications 1 à 11, caractérisé en ce que les autres éléments du tiroir peuvent être combinés, selon l'équipement de tiroir prévu, avec des parois frontales (11, 60) présentant des formes différentes.

13. Tiroir selon au moins l'une quelconque des revendications 1 à 12, caractérisé en ce qu'au moyen des vis (18, 19) reliant la paroi frontale (11, 60) à l'élément de fond (10, 57) à l'endroit des canaux circulaires (40) de ce dernier, on peut en même temps fixer une poignée de tiroir (15) sur la paroi frontale.

14. Tiroir selon au moins l'une quelconque des revendications 1 à 13, caractérisé en ce que le rail de support (37) du tiroir se trouvant dans l'armoire d'installation et s'engageant dans la partie en creux (36) en C sur la surface de fond (35) de l'élément de fond (10, 57) est un rail à profil en T (37) ou un rail à profil en chapeau (52, 53).

15. Tiroir selon au moins l'une quelconque des revendications 1 à 13, caractérisé en ce que le dispositif de support du tiroir, se trouvant dans l'armoire d'installation et s'engageant dans la partie en creux (36) en C sur la surface de fond (35) de l'élément de fond (10, 57), est une paire de rails en U ou de cornières (54, 55).

16. Tiroir selon au moins l'une quelconque des revendications 8 à 10, caractérisé en ce que les panneaux latéraux (13, 14) présentent dans les zones de bord de leurs extrémités longitudinales des évidements pour la réception de saillies formées sur la paroi frontale (11) et de la paroi arrière (12).

Fig.1

0 109 569

Fig.6

39

55

36

10

B →

51

26

12

Fig.5

54

36

10

13

39

Fig.4

53

10

50

51

Fig.3

10

13

35

52

46

Fig.2

45

A

41

42

44

47

40

43

39

38

49

10

35

36

37

48

Fig.7